# EUROPÄISCHE PATENTSCHRIFT

(11) **EP 1 130 735 B1**
(45) Veröffentlichungstag und Bekanntmachung des Hinweises auf die Patenterteilung: **03.01.2007**
(21) Anmeldenummer: 01100334.0
(22) Anmeldetag: 04.01.2001
(51) Int. Cl.: H03G 3/30

(54) **Schaltungsanordnung zur Regelung der Sendeleistung eines batteriebetriebenen Funkgeräts**
Circuit arrangement for regulating the transmission power of a battery operated radio device
Circuit pour régler le puissance d'émission d'un dispositif radio à batterie

(30) Priorität: 21.01.2000 DE 10002523
(43) Veröffentlichungstag der Anmeldung: 05.09.2001
(73) Patentinhaber: Infineon Technologies AG, 81669 München (DE)
(72) Erfinder: Wahl, Martin, 81377 München (DE)
(74) Vertreter: Epping - Hermann - Fischer

(56) Entgegenhaltungen:
- US-A- 4 709 404
- US-A- 5 896 261

## Beschreibung

Die Erfindung betrifft eine Schaltungsanordnung zur Regelung der Sendeleistung eines batteriebetriebenen Funkgerätes mit einer Batterie zur Bereitstellung einer Versorgungsspannung sowie einer Leistungsstufe zur steuerbaren Verstärkung eines Hochfrequenzsignals.

Mobile Funkgeräte, insbesondere zellulare digitale Mobiltelefone, werden von einer Batterie mit Spannung versorgt. Je höher die Sendeleistung des Mobiltelefons ist, desto höher ist der aus der Batterie gezogene Strom. Der durch die Batterie fließende Strom verursacht an deren Innenwiderstand einen Spannungsabfall. Bei höherem Strom sinkt dementsprechend die für die zu versorgende Schaltung bereitgestellte Spannung. Diese belastete Spannung ist daher niedriger als die Leerlaufspannung. Wenn die von der Batterie gelieferte Betriebsspannung nicht mehr für einen einwandfreien Betrieb des Mobilfunkgerätes ausreicht, wird das Gerät abgeschaltet.

Bei Mobiltelefonen kann die das zur Abstrahlung dienende Sendesignal erzeugende Leistungsendstufe direkt, d.h. ohne Pufferung, zusammen mit weiteren Schaltungseinheiten des Mobiltelefons an die Batterie angeschlossen sein. Die weiteren Verbraucher können digitale Schaltungen wie Microcontroller, digitale Signalprozessoren, Referenztaktgeneratoren etc. sein. Aufgrund der digitalen Systemsteuerung wird die Abschaltung infolge nicht ausreichender Versorgungsspannung durch diese letztgenannten Verbraucher bestimmt. Der aufgrund höherer Sendeleistung zusätzlich verbrauchte Strom und der dadurch am Innenwiderstand der Batterie zusätzlich erzeugte Spannungsabfall bewirkt ein früheres Abschalten des Gerätes. Die Nominalleistung des Mobiltelefons wird während der Fertigung individuell abgeglichen.

Problematisch ist, daß gerade bei hoher Sendeleistung die Batterie schnell entladen wird und ein Telefongespräch durch die automatische Abschaltsteuerung abrupt beendet werden kann, ohne daß die Bedienperson ausreichend schnell darauf reagieren könnte. Der Bedienungskomfort und die Einsatzmöglichkeiten solcher Mobiltelefone werden dadurch eingeschränkt.

In der Druckschrift US 4,709,404 wird ein batteriebetriebenes Funkkommunikationsgerät beschrieben, das einen Leistungsverstärker und einen Leistungsdetektor zur Detektion einer Ausgangsleistung des Leistungsverstärkers umfasst. Eine Detektoreinrichtung zur Detektion eines Spannungspegels vergleicht eine Referenzspannung mit der Ausgangsspannung einer Batterie zur Spannungsversorgung des Funkkommunikationsgerätes. Eine Steuereinrichtung steuert die Ausgangsleistung des Leistungsverstärkers in Abhängigkeit von der von der Detektoreinrichtung detektierten Batteriespannung, um die Betriebsbereitschaft des Funkkommunikationsgerätes bei abnehmender Batteriespannung zu verlängern.

Die Aufgabe der Erfindung besteht darin, eine Schaltungsanordnung zur Regelung der Sendeleistung eines batteriebetriebenen Funkgerätes anzugeben, bei dem bei ausreichend zur Verfügung stehender Batteriespannung und bei abnehmbarer Batteriespannung, die Betriebszeit verlängerbar ist.

Gemäß der Erfindung wird diese Aufgabe durch eine Schaltungsanordnung zur Regelung der Sendeleistung eines batteriebetriebenen Funkgeräts gelöst, die umfaßt: eine Batterie zur Bereitstellung einer Versorgungsspannung; eine Leistungsstufe zur steuerbaren Verstärkung eines Hochfrequenzsignals; eine Vergleichseinrichtung, der eingangsseitig ein an die Versorgungsspannung gekoppeltes Signal zuführbar ist sowie ein Referenzsignal und durch die ausgangsseitig ein Differenzsignal erzeugbar ist, und eine Steuerungseinrichtung zur Steuerung der Verstärkung der Leistungsstufe in Abhängigkeit vom Differenzsignal. Erfindungsgemäß erzeugt die Vergleichseinrichtung das Differenzsignal mit einem Pegel zu Null, wenn die Versorgungsspannung oberhalb der Referenzspannung liegt, und mit einem Pegel positiv verschieden von Null, wenn die Versorgungsspannung unterhalb der Referenzspannung liegt. Es ist darüber hinaus ein Verknüpfungsglied vorgesehen, durch das eine Differenz des Differenzsignals und eines weiteren Referenzsignals erzeugbar ist und das ausgangsseitig ein Steuerungssignal erzeugt, welches der Leistungsstufe zur Steuerung von deren Verstärkung zuführbar ist.

Bei einer Schaltungsanordnung gemäß der Erfindung wird abhängig von der Batteriespannung die Sendeleistung des Funkgerätes reduziert. Hierzu wird der Sollwert der Leistungsregelung in Abhängigkeit von der Batteriespannung erniedrigt. Wenn bei einem Mobilfunkgerät mit einer solchen Schaltungsanordnung am Ende der Batterieladung ein Telefongespräch geführt wird, verlängert sich die Verfügbarkeit der Batterie aufgrund zweier Effekte: einerseits durch die verringerte Leistungsaufnahme, so daß weniger Strom aus der Batterie gezogen wird und dadurch ausreichend Batterieladung bei gegebener Kapazität länger zur Verfügung steht; und andererseits durch den verringerten Spannungsabfall am Innenwiderstand der Batterie aufgrund des geringeren Laststroms, so daß die Abschaltung des Gerätes verzögert wird.

Da die Vergleichseinrichtung das Differenzsignal mit einem Pegel zu Null erzeugt, wenn die Versorgungsspannung oberhalb der Referenzspannung liegt, und ein Verknüpfungsglied vorgesehen ist, mit dem ein Steuerungssignal zur Steuerung der Verstärkung der Leistungsendstufe erzeugbar ist, indem eine Differenz des Differenzsignals und eines weiteren Referenzsignals erzeugbar ist, wird es ermöglicht, bei noch ausreichend zur Verfügung stehender Batteriespannung mittels des Pegels des Referenzssignals eine Sollleistung vorzugeben, die an die vorherrschenden Sende- und Empfangsbedingungen angepasst ist. Dadurch wird bereits bei noch ausreichend zur Verfügung stehender Batteriespannung eine Maßnahme ermöglicht, um der schnellen Entladung der Batterie entgegen zu wirken beziehungsweise um die Lebensdauer der Batterie zu verlängern.

Bei der erfindungsgemäßen Schaltung wird die Leistungsverringerung mittels analoger Schaltungsmaßnahmen erreicht. Es sind nur relativ wenige zusätzliche Komponenten erforderlich, die preisgünstig in einen der integrierten Schaltkreise des Funkgerätes aufgenommen werden können. Digitaler Rechenaufwand ist nicht erforderlich, so daß die übrige digitale Systemsteuerung der Schaltung nicht mit zusätzlichem Rechenaufwand beeinflußt wird. Die Leistungsregelung arbeitet kontinuierlich, so daß die Leistungsverringerung dafür sorgt, daß das Gerät möglichst lange und mit möglichst großer Leistung in Betrieb bleiben kann. Die Dauer eines gerade geführten Telefongesprächs bei geringer Batterieladung wird daher so weit wie möglich verlängert.

In Ausgestaltung der Erfindung wird ein Signal, das von einem an die Batteriespannung angeschlossenen Spannungsteiler erzeugt wird, mit einem Referenzsignal verglichen und ein Differenzsignal erzeugt. In Abhängigkeit von diesem Differenzsignal wird die Leistung der Leistungsendstufe gesteuert. Das Differenzsignal wird von einem vorgegebenen konstanten Sollwert subtrahiert. Dieser nachgeführte Sollwert wiederum wird mit einem die Sendeleistung repräsentierenden Signal verglichen, so daß das erhaltene Differenzsignal direkt die Treiberstufen der Endstufe steuert. Die Sendeleistung läßt sich beispielsweise mittels eines herkömmlichen Richtkopplers und einer Detektordiode ermitteln. Die Nachführung des Sollwerts für die Sendeleistung wird erst dann aktiviert, wenn die abgegebene belastete Batteriespannung unter dem eingangs genannten Schwellwert liegt. Ein bevorzugtes Anwendungsgebiet der Erfindung liegt auf dem Gebiet von Mobiltelefonen, die für heutige und zukünftige zellulare, digitale Mobiltelefonnetze entworfen werden.

Nachfolgend wird die Erfindung anhand der in der Zeichnung dargestellten Figuren an einem Ausführungsbeispiel erläutert. Entsprechende Elemente sind mit gleichen Bezugszeichen versehen. Es zeigen:
- Figur 1: eine Schaltungsanordnung gemäß der Erfindung
- Figur 2: die Kennlinie eines Vergleichers, der Schaltung aus Figur 1 und
- Figur 3: ein Prinzipschaltbild der Batterie eines Mobilfunkgerätes mit angeschlossenen Lasten.

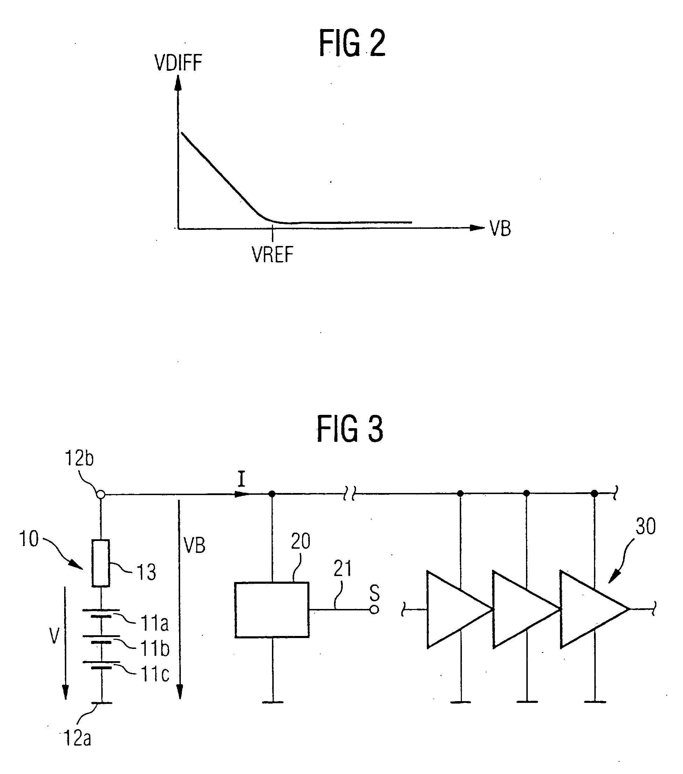

Die Schaltung in Figur 3 zeigt eine Batterie 10, die drei Batteriezellen 11a, 11b und 11c umfaßt, die in Reihe geschaltet sind. Von den drei Batteriezellen 11a, ..., 11c wird die Spannung V eingeprägt. Bei zunehmender Entladung der Batterie sinkt die Spannung V ab. Innerhalb der Batterie sind die Batteriezellen 11a, 11b und 11c mit einem Innenwiderstand 13 in Reihe geschaltet. Die Betriebsspannung VB, die das Mobilfunkgerät versorgt, liegt an den Anschlüssen 12a und 12b an. In Abhängigkeit von dem aus der Batterie gezogenen Strom I fällt am Innenwiderstand 13 eine dementsprechend hohe Spannung ab. Die vom Stromverbrauch im Gerät belastete Betriebsspannung VB ergibt sich aus der Zellenspannung V abzüglich dem am Widerstand 13 vom Betriebsstrom I erzeugten Spannungsabfall. Je höher der Betriebsstrom I ist, desto niedriger ist bei gleicher Zellenspannung V die belastete Betriebsspannung VB. Außerdem verringert sich mit zunehmender Entladung der Batteriezellen auch die von diesen gelieferte Zellenspannung V.

Von der Betriebsspannung VB werden sämtliche Funktionseinheiten des Mobilfunkgerätes versorgt. Diese Funktionseinheiten umfassen digitale Schaltungsteile 20, beispielsweise Microcontroller, digitale Signalprozessoren, Taktgeneratoren etc. Die von diesen Schaltungen digital aufbereiteten Sprachsignale werden über eine Hochfrequenzendstufe 30 abgestrahlt. Im gezeigten Ausführungsbeispiel besteht die Leistungsendstufe 30 aus drei in Reihe geschalteten Einzelverstärkern. Die Leistungsendstufe 30 wird ebenfalls aus der Batteriespannung VB gespeist. Bei höherer Sendeleistung der Endstufe 30 steigt der aus der Batterie gezogene Strom I. Die Versorgungsspannung VB für die digitalen Schaltungsteile 20 sinkt dann. Im Microcontroller sind geeignete Schaltungen enthalten, durch welche die Betriebsspannung VB abgefragt wird. Wenn die Betriebsspannung VB unter einen Schwellwert sinkt, wird dies vom Microcontroller festgestellt und ein Abschaltsignal S an einem Anschluß 21 erzeugt. Dies hat zur Folge, daß das Mobilfunkgerät abgeschaltet wird, da nicht mehr sichergestellt ist, daß die Funktionseinheiten des Mobilfunkgerätes, insbesondere die digitalen Schaltungsteile, ausreichend zuverlässig arbeiten.

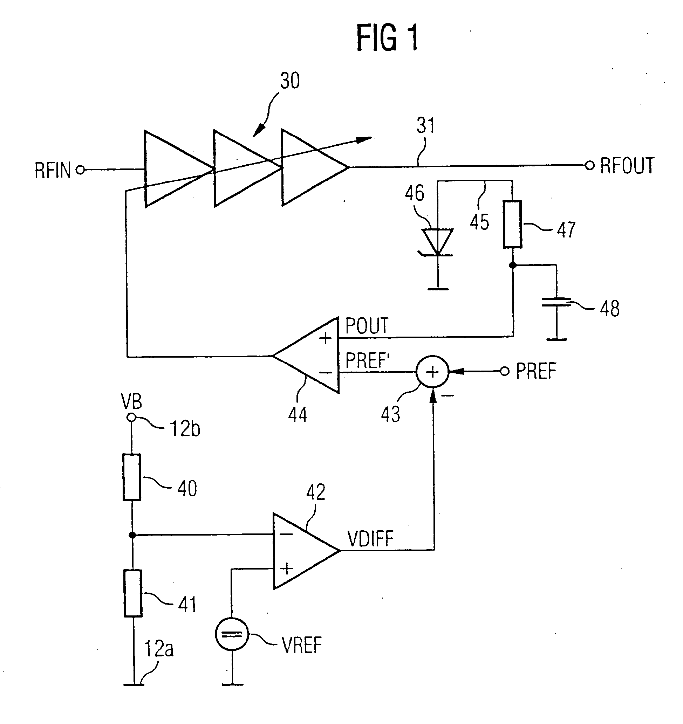

Um das Abschalten des Mobiltelefons während eines langdauernden Gespräches bei hoher Sendeleistung möglichst lange hinauszögern, wird die in Figur 1 dargestellte Schaltung verwendet. Durch die Schaltung wird der variable Teil der Leistungsaufnahme des Mobiltelefons, nämlich die Sendeleistung verringert. Dadurch sinkt der aus der Batterie gezogene Strom I und dementsprechend der Spannungsabfall am Innenwiderstand 13 der Batterie, so daß sich die belastete Betriebsspannung VB erhöht und das Erzeugen des Abschaltsignals S durch die digitalen Schaltungen 20 verzögert wird. Der Standard GSM (Global System for Mobile Communication) für digitale zellulare Mobiltelefone ermöglicht eine Reduktion der Sendeleistung unter extremen Bedingungen, beispielsweise bei zur Neige gehender Batterieladung.

Die in Figur 1 gezeigte Schaltung fragt die für die Versorgung des Mobiltelefons bereitstehende belastete Batteriespannung VB ab und erzeugt, bezogen auf eine Referenzspannung VREF ein Differenzsignal VDIFF. Das Differenzsignal VDIFF dient zur Nachführung einer vorgegebenen Sollleistung PREF. Die Sollleistung PREF wird von der Gerätesteuerung entsprechend den Sende- und Empfangsbedingungen vorgegeben. Die Nominalsendeleistung wird üblicherweise bei der Herstellung des Mobiltelefons individuell für das Gerät programmiert. Die nachgeführte Sollleistung PREF' dient schließlich zur Leistungssteuerung der steuerbaren Hochfrequenzendstufen 30.

Die Schaltung in Figur 1 ist im Detail wie folgt aufgebaut. Ein Spannungsteiler 40, 41 ist zwischen die Anschlüsse 12a und 12b der von der Batterie gelieferten Betriebsspannung VB geschaltet. Der Ausgang des Spannungsteilers 40, 41, d.h. der zwischen den Widerständen 40, 41 liegende Schaltungsknoten, ist an den Minus-Eingang eines Komparators 42 angeschlossen. Der Plus-Eingang des Komparatos 42 wird von einer festen, von Schwankungen der Betriebsspannung unabhängigen Referenzspannung VREF gespeist. Schaltungen zur Bereitstellung einer versorgungsspannungsunabhängigen Konstantspannung sind mannigfach bekannt. Am Ausgang des Komparators 42 steht das Differenzsignal VDIFF zur Verfügung, welches angibt, um wieviel die Versorgungsspannung VB unterhalb der Referenzspannung VREF liegt. Das Differenzsignal VDIFF wird einem Eingang eines Summierers 43 negiert zugeführt. Am anderen Eingang des Summierers 43 wird das die Sollleistung repräsentierende Signal PREF eingespeist. Der Ausgang des Summierers 43 liefert das Signal PREF', welches die entsprechend dem Absinken der Versorgungsspannung VB unter die Referenzspannung VREF nachgeführte Sollleistung repräsentiert. Das Signal PREF' wird dem Minus-Eingang eines weiteren Komparators 44 zugeführt. Am Plus-Eingang des Komparators 44 wird ein Signal Pₒᵤₜ eingespeist, das ein Maß für die von der Leistungsstufe 30 abgegebene Hochfrequenzausgangsleistung ist. Um das Signal POUT zu erzeugen, ist ein Kopplungsglied 45 vorgesehen, welches an den Ausgang 31 der letzten Stufe des Leistungsverstärkers 30 gekoppelt ist. Die Hochfrequenzeinkopplung im Kopplungsglied 45 erzeugt an einer Schottky-Diode 46 eine auf Masse bezogene Spannung. Die Schottky-Diode 46 dient dazu, die Hochfrequenzamplitude des Signals zu ermitteln, die an demjenigen Tor des Kopplungsglieds 45 anliegt, welches die weglaufende Welle detektiert. An einem Widerstand 47 sind die Änderungen der Ausgangsleistung meßbar. Der Widerstand 47 ist in die zum Plus-Eingang des Komparators 44 führende Signalleitung geschaltet. Der Widerstand 47 ist zusätzlich über einen Kondensator 48 nach Masse geschaltet, um eine RC-Tiefpaßfilterung zu bewirken. Das Ausgangssignal des Komparators 44 dient zur Leistungssteuerung der Endstufe 30. Dieser wird eingangsseitig ein Hochfrequenzsignal RFIN zugeführt, das innerhalb der Leistungsstufe 30 verstärkt wird und als Ausgangssignal RFOUT abgegeben wird, um über die Antenne des Mobiltelefons abgestrahlt zu werden.

Der Komparator 42, welcher die Batteriespannung VB mit der Referenzspannung VREF vergleicht, hat prinzipiell die in Figur 2 dargestellte Kennlinie. Wenn die belastete Batteriespannung VB oberhalb der Referenzspannung VREF liegt, ist das Ausgangssignal VDIFF des Komparators 42 Null. Dies bedeutet, daß der nachgeführte Sollwert für die Ausgangsleitung PREF' gleich dem vorgegebenen Sollwert PREF ist. Die Leistungsendstufe 30 wird bei hoher zur Verfügung stehender Batteriespannung VB entsprechend den erforderlichen Gegebenheiten voll ausgesteuert. Wenn die zur Verfügung stehende Batteriespannung VB unterhalb der Referenzspannung VREF liegt, ist das vom Komparator 42 ausgangsseitig erzeugte Differenzsignal VDIFF positiv verschieden von Null. Zweckmäßigerweise besteht dann wie in Figur 2 gezeigt zwischen der Betriebsspannung VB und der Differenzspannung VDIFF ein linearer Zusammenhang. Dies bedeutet, daß mit sinkender Batteriespannung VB (VB < VREF) die Differenzspannung VDIFF längs einer Gerade zu positiven Werten hin ansteigt. Dies bewirkt, daß der nachgeführte Sollwert für die Ausgangsleistung PREF' gegenüber dem von der Schaltung bereitgestellten Sollwert PREF verringert wird. Dementsprechend wird die Sendeleistung der Endstufe 30 gleichermaßen niedriger eingestellt. Als Folge davon sinkt der aus der Batterie gezogene Strom I, so daß der Vorrat an Batterieladung weniger schnell verbraucht wird. Außerdem sinkt die am Innenwiderstand 13 der Batterie abfallende Spannung, so daß die Betriebsspannung VB ansteigt und das Abschalten des Gerätes durch die digitalen Schaltungen 20 verzögert wird. Auf diese Weise wird das gerade vom Benutzer des Mobiltelefons geführte Gespräch verlängert. Je niedriger die Betriebsspannung VB aufgrund der zur Neige gehenden Batterieladung wird, desto niedriger wird die durch die Leistungsendstufe 30 abgegebene Sendeleistung eingestellt. Vorteilhafterweise wird dadurch die Gesprächsdauer möglichst lange mit möglichst hoher Sendeleistung aufrecht erhalten. Diese Verlängerung wird jedoch mit einer aufgrund geringerer Sendeleistung höheren Bit-Fehlerrate erkauft, was jedoch durch den erreichten Vorteil mehr als aufgewogen wird. Diese Lösung ist mit dem GSM-Standard, der eine Reduktion der Leistung vorsieht, vereinbar.

Die vorgeschlagenen Schaltungsmaßnahmen arbeiten analog und greifen nicht in die digitale Steuerung des Microcontrollers des Mobiltelefons ein. Die geringe Anzahl der zusätzlichen Komponenten 40, ..., 43 kann ohne weiteres auf dem die Sendeleistung einstellenden integrierten Schaltkreis mit aufgenommen werden. Der zusätzliche Schaltungsaufwand wird daher die Herstellungskosten des Chipsatzes für Mobiltelefone kaum nennenswert erhöhen.

## Patentansprüche

1. Schaltungsanordnung zur Regelung der Sendeleistung eines batteriebetriebenen Funkgeräts, die umfaßt:
- eine Batterie (10) zur Bereitstellung einer Versorgungsspannung (VB),
- eine Leistungsstufe (30) zur steuerbaren Verstärkung eines Hochfrequenzsignals (RFIN),
- eine Vergleichseinrichtung (42), der eingangsseitig ein an die Versorgungsspannung (VB) gekoppeltes Signal zuführbar ist sowie ein Referenzsignal (VREF) und durch die ausgangsseitig ein Differenzsignal (VDIFF) erzeugbar ist, und
- eine Steuerungseinrichtung (43, ..., 48) zur Steuerung der Verstärkung der Leistungsstufe (30) in Abhängigkeit vom Differenzsignal (VDIFF),
**dadurch gekennzeichnet, daß**
die Vergleichseinrichtung (42) das Differenzsignal (VDIFF) mit einem Pegel zu Null erzeugt, wenn die Versorgungsspannung (VB) oberhalb der Referenzspannung (Vref) liegt, und die Vergleichseinrichtung (42) das Differenzsignal (VDIFF) mit einem Pegel positiv verschieden von Null erzeugt, wenn die Versorgungsspannung (VB) unterhalb der Referenzspannung (Vref) liegt und
ein Verknüpfungsglied (43) vorgesehen ist, durch das eine Differenz des Differenzsignals (VDIFF) und eines weiteren Referenzsignals (PREF) erzeugbar ist und das ausgangsseitig ein Steuerungssignal erzeugt, welches der Leistungsstufe (30) zur Steuerung von deren Verstärkung zuführbar ist.

2. Schaltungsanordnung nach Anspruch 1, **gekennzeichnet durch**
einen Spannungsteiler (40, 41), der eingangsseitig zwischen Anschlüsse für die Versorgungsspannung (VB) geschaltet ist und der ausgangsseitig mit einem Eingang der Vergleichseinrichtung (42) verbunden ist.

3. Schaltungsanordnung nach Anspruch 1 oder 2, **gekennzeichnet durch**
eine Meßeinrichtung (45, ..., 48) zur Messung der Leistung eines von der Leistungsstufe (30) ausgegebenen Signals (RFOUT), eine weitere Vergleichseinrichtung (44), die eingangsseitig mit einem Ausgang der Meßeinrichtung (45, ..., 48) gekoppelt ist sowie mit einem Ausgang des Verknüpfungsglieds (43) und **durch** die ausgangsseitig das Steuersignal zur Steuerung der Leistung der Leistungsstufe (30) erzeugbar ist.

4. Schaltungsanordnung nach Anspruch 3,
**dadurch gekennzeichnet, daß**
die Meßeinrichtung (45, ..., 48) einen Richtkoppler umfaßt, der enthält: ein Kopplungsglied (45), das mit dem Ausgang der Leistungsstufe (30) gekoppelt ist, einem an das Kopplungsglied (45) angeschlossenen eine Hochfrequenzamplitude detektierenden Element (46), einen Widerstand (47), der zwischen das Kopplungsglied (45) und einem Eingang der weiteren Vergleichseinrichtung (44) geschaltet ist.

5. Schaltungsanordnung nach Anspruch 4,
**dadurch gekennzeichnet , daß**
das die Hochfrequenzamplitude detektierende Element eine Schottky-Diode (46) ist, die an dem Tor des Kopplungsglieds (45), welches die von der Leistungsstufe (30) weglaufende Welle detektiert, angeschlossen ist.

6. Schaltungsanordnung nach einem der Ansprüche 1 bis 5, **gekennzeichnet durch**
eine von der Versorgungsspannung (VB) gespeiste digital arbeitende Funktionseinheit (20), **durch** die in Abhängigkeit von der Versorgungsspannung (VB) ein Abschaltsignal (S) erzeugbar ist, um das Funkgerät abzuschalten.

7. Verwendung einer Schaltungsanordnung nach einem der Ansprüche 1 bis 6,
in einem Mobiltelefon, das für den Betrieb in einem zellularen Telefonnetz geeignet ist.

## Claims

1. Circuit arrangement for controlling the transmission power of a battery-operated radio, which arrangement comprises the following:
- a battery (10) for providing a supply voltage (VB),
- a power stage (30) for the controllable amplification of a radio-frequency signal (RFIN),
- a comparison device (42), whose input can be supplied with a signal coupled to the supply voltage (VB) and a reference signal (VREF) and by means of which a difference signal (VDIFF) can be produced at the output, and
- a control device (43, ..., 48) for controlling the gain of the power stage (30) as a function of the difference signal (VDIFF), **characterized in that**
the comparison device (42) produces the difference signal (VDIFF) with a level tending to zero when the supply voltage (VB) is above the reference voltage (Vref), and the comparison device (42) produces the difference signal (VDIFF) at a positive level other than zero when the supply voltage (VB) is below the reference voltage (Vref),
and a logic element (43) is provided, by means of which any difference between the difference signal (VDIFF) and a further reference signal (PREF) can be produced and which produces at the output a control signal which can be supplied to the power stage (30) for controlling its gain.

2. Circuit according to Claim 1, **characterized by** a voltage divider (40, 41) which is connected at its input between connections for the supply voltage (VB) and is connected at its output to an input of the comparison device (42).

3. Circuit arrangement according to Claim 1 or 2, **characterized by** a measuring device (45, ..., 48) for measuring the power of a signal (RFOUT) emitted from the power stage (30), a further comparison device (44) which is coupled at its input to an output of the measuring device (45, ..., 48) and to an output of the logic element (43) and by means of which, at its output, the control signal for controlling the power of the power stage (30) can be produced.

4. Circuit arrangement according to Claim 3, **characterized in that** the measuring device (45, ..., 48) comprises a directional coupler which contains the following: a coupling element (45) which is coupled to the output of the power stage (30), an element (46) which, connected to the coupling element (45), detects a radio-frequency amplitude, and a resistor (47) which is connected between the coupling element (45) and one input of the further comparison device (44).

5. Circuit arrangement according to Claim 4, **characterized in that** the element detecting the radio-frequency amplitude is a Schottky diode (46) which is connected to the gate of the coupling element (45) which detects the wave moving away from the power stage (30).

6. Circuit arrangement according to one of Claims 1 to 5, **characterized by** a digitally operating functional unit (20) supplied by the supply voltage (VB), which unit can produce a switching-off signal (S) as a function of the supply voltage (VB), in order to switch off the transceiver.

7. Use of a circuit arrangement according to one of Claims 1 to 6 in a mobile telephone which is suitable for operation in a cellular telephone network.

## Revendications

1. Montage de régulation de la puissance d'émission d'un appareil radio alimenté par batterie, qui comprend
- une batterie (10) pour disposer d'une tension (VB) d'alimentation ;
- un étage (30) de puissance, pour amplifier de manière réglable un signal (RFIN) de haute fréquence ;
- un dispositif (42) de comparaison, auquel peut être envoyé du côté entrée un signal couplé à la tension (VB) d'alimentation ainsi qu'un signal (VREF) de référence et par lequel il peut être produit du côté sortie un signal (VDIF) de différence ; et
- un dispositif (43, ..., 48) de commande de l'amplification de l'étage (30) de puissance en fonction du signal (VDIF) de différence ;
**caractérisé en ce que**
le dispositif (42) de comparaison produit le signal (VDIF) de différence ayant un niveau positif différent de zéro lorsque la tension (VB) d'alimentation est inférieure à la tension (VREF) de référence ; et
il est prévu un élément (43) de combinaison logique par lequel il peut être produit une différence entre le signal (VDIF) de différence et un autre signal (VREF) de référence et qui produit du côté sortie un signal de commande qui peut être envoyé à l'étage (30) de puissance pour en régler l'amplification.

2. Montage suivant la revendication 1,
**caractérisé par**
un diviseur (40, 41) de tension qui est monté du côté entrée entre des bornes pour la tension (VB) d'alimentation et qui est relié du côté sortie à une entrée du dispositif (42) de comparaison.

3. Montage suivant la revendication 1 ou 2,
**caractérisé par**
un dispositif (45, ..., 48) de mesure de la puissance d'un signal (RFOUT) émis par l'étage (30) de puissance, un autre dispositif (44) de comparaison qui est couplé du côté entrée à une sortie du dispositif (45, ..., 48) de mesure ainsi qu'à une sortie de l'élément (43) de combinaison logique et par lequel peut être produit du côté sortie le signal de commande de la puissance de l'étage (30) de puissance.

4. Montage suivant la revendication 3,
**caractérisé en ce que**
le dispositif (45, ..., 48) de mesure comprend un coupleur directif qui comporte : un élément (45) de couplage qui est couplé à la sortie de l'étage (30) de puissance, un élément (46) raccordé à l'élément (45) de couplage et détectant des amplitudes de haute fréquence, une résistance (47) qui est montée entre l'élément (45) de couplage et une entrée de l'autre dispositif (44) de comparaison.

5. Montage suivant la revendication 4,
**caractérisé en ce que**
l'élément détectant des amplitudes de haute fréquence est une diode (46) de Schottky, qui est reliée à la porte de l'élément (45) de couplage qui détecte l'onde partant de l'étage (30) de puissance.

6. Montage suivant l'une des revendications 1 à 5,
**caractérisé par**
une unité (20) fonctionnelle qui est alimentée par la tension (VB) d'alimentation, qui fonctionne de manière numérique et par laquelle un signal (S) de mise hors circuit peut être produit en fonction de la tension (VB) d'alimentation pour mettre l'appareil radio hors circuit.

7. Utilisation d'un montage suivant l'une des revendications 1 à 6,
dans un téléphone mobile qui est approprié pour le fonctionnement dans un réseau téléphonique cellulaire.
